# EUROPÄISCHE PATENTSCHRIFT

(11) **EP 3 619 180 B1**
(45) Veröffentlichungstag und Bekanntmachung des Hinweises auf die Patenterteilung: **18.01.2023**
(21) Anmeldenummer: 18720232.0
(22) Anmeldetag: 25.04.2018
(51) Int. Cl.: C04B 28/02, C04B 40/02, H01L 23/29, C04B 111/00, C04B 111/26

(54) **VERFAHREN ZUR HERSTELLUNG EINER ELEKTRISCHEN VORRICHTUNG MIT EINER UMHÜLLMASSE**
METHOD FOR PRODUCING AN ELECTRICAL DEVICE COMPRISING A COVERING MATERIAL
PROCÉDÉ DE FABRICATION D'UN DISPOSITIF ÉLECTRIQUE COMPRENANT UNE MATIÈRE D'ENROBAGE

(30) Priorität: 03.05.2017 DE 102017207424
(43) Veröffentlichungstag der Anmeldung: 11.03.2020
(73) Patentinhaber: Robert Bosch GmbH, 70442 Stuttgart (DE)
(72) Erfinder: HAMMER-ALTMANN, Marianne, 69469 Weinheim (DE)
(86) Internationale Anmeldenummer: PCT/EP2018/060577
(87) Internationale Veröffentlichungsnummer: WO 2018/202498

(56) Entgegenhaltungen:
- WO-A1-2017/089210
- DE-A1-102013 112 267
- US-A- 3 238 279
- US-A- 5 935 317
- Liudvikas Urbanas ET AL: "Einfluss der beschleunigten Carbonatisierung mit überkritischem CO2 auf die Eigenschaften von Zementstein", Wissenschaftlicher Kurzbericht Nr. 24, 2011, Seiten 1-2, XP055488768, München, Germany Gefunden im Internet: URL:https://www.cbm.bgu.tum.de/fileadmin/w 00bdr/www/pdf/Kurzberichte/KB_24.pdf [gefunden am 2018-06-28]

## Beschreibung

Die vorliegende Erfindung betrifft ein Verfahren zur Herstellung einer elektrischen Vorrichtung mit einem elektrischen oder elektronischen Bauteil, wobei das Bauteil von einer Zement aufweisenden Umhüllmasse zumindest teilweise umhüllt wird, und eine derartige elektrische Vorrichtung.

### Stand der Technik

Die Erhöhung der Zuverlässigkeit und der Effizienz sowie die Senkung der Kosten von Leistungselektronik (LE)-Modulen und robusten Sensorsystemen sind heutzutage von höchster Bedeutung. Die aktuellen Umhüllmaterialien (Epoxid-Verbindungen, Silikonmassen) sind auf einen Temperaturbereich von unter 200°C begrenzt. Durch die Erschließung des Temperaturbereiches von bis zu 300°C bzw. 350°C für Umhüllmaterialien kann der Betriebsbereich von modernen Leistungshalbleitern (z.B. SiC) über 200°C hinaus erweitert werden, ohne dass auf die Zusatzfunktion eines Umhüllmaterials (z.B. Schutz vor Umwelteinflüssen, verbesserte Thermik) verzichtet werden muss.

LE-Module bestehen aus vielen keramischen und metallischen Materialpaarungen, die unter bestimmten Bedingungen untereinander reagieren können. Vor allem Feuchtigkeit, Gase und erhöhte Temperatur lassen chemische Reaktionen bevorzugt ablaufen. Eine mögliche Korrosion kann die Funktionsfähigkeit beeinträchtigen. Die Korrosion stellt hierbei einen Angriff auf den Werkstoff durch Reaktion mit seiner Umgebung dar, wobei sich Werkstoffeigenschaften verschlechtern.

Eine der schädigenden Reaktionen für Metalle, welche in Umhüllmassen aus Zement bzw. auf Zement basierenden Umhüllmassen angeordnet sind, ist die Carbonatisierung des Zements in der Umhüllmasse nach der Erhärtung bzw. Hydratation. Unter Carbonatisierung ist die chemische Umwandlung von Ca(OH)₂ und den alkalischen Bestandteilen (und NaOH und KOH) des Zementsteines, durch das in der Luft enthaltene CO2 in Calciumcarbonat zu verstehen:

Ca(OH)2+ CO2+ H2O → CaCO3 + 2H2O und 2NaOH + CO2 → Na2CO3 + H2O

Phasen der Carbonatisierung:
1. Lösen des kristallinen Portlandit im Feuchtigkeitsfilm an den Porenwandungen der Zementmasse. Parallel dazu erfolgt die Diffusion von CO2 aus der Luft in die Kapillarporen.

   Ca(OH)2→ Ca2+ + 2OH-
2. CO2 reagiert mit einem geringen Teil des Wassers zu Kohlensäure, die in Wasser zu H+ und CO2- dissoziiert

   CO2+ H2O → H2CO3 → 2H+ + CO2-3
3. Neutralisation von Ca(OH)2 durch H2CO3

   Ca(OH)2+ H2CO3→ CaCO3+ 2H2O

   (CaCO3 als Calcit und selten als Vaterit (hohe Alkalität) oder Aragonit (niedrige Alkalität) → CaCO3-Modifikationen)
4. Carbonatisieren der Alkalihydroxide NaOH und KOH und Weiterreaktion zu Calciumcarbonat und Alkalihydroxid

   2NaOH + CO2 → Na2CO3 + H2O und Na2CO3 + Ca(OH)2 → CaCO3 + 2NaOH

Infolge der Carbonatisierung aus der Porenlösung, d.h. der Lösung an der Porenwandung entsteht ein Mangel an gelöstem Ca(OH)2, so dass kristalliner Portlandit aufgelöst wird. Der hohe pH-Wert (ca. 12,5) der Porenlösung bleibt nur solange erhalten, wie Ca(OH)2 und Alkalien vorliegen. Bei pH-Werten größer 10 bildet sich bspw. bei Stahlbeton auf der Stahloberfläche, welche mit dem Zement in Kontakt ist, eine Passivschicht aus (2 bis 20 nm), die den Stahl vor Korrosion schützt. Bei Einflüssen, die zu einer Neutralisierung der Porenlösung führen, sinkt jedoch der pH-Wert auf etwa 9, so dass eine Korrosionsgefahr besteht. Demnach führt die Carbonatisierung zu einer pH-Wert Absenkung von 12,5 auf ca. 9. Grund ist der "Verbrauch" von Ca(OH)2:

Ca(OH)2 + CO2 → CaCO3 + H2O

Folglich kann die Abnahme der Alkalität aufgrund der Carbonatisierung zu einer Korrosion von Stahl aber auch bestimmter weiterer Metalle führen, was wiederum Einfluss auf die Stabilität dieser Metalle hat. Andererseits führt die Carbonatisierung jedoch auch zu einer Dichtezunahme des carbonatisierten Zements

Die Voraussetzungen für eine Carbonatisierung des Zements sind:
- Kontakt des Zements mit CO2, bspw. mit Luft (Gehalt CO2 in Luft ist 0,04%)
- Vorhandensein von Kapillarporen, in die das CO2 vordringen kann
- Ausreichende Feuchtigkeitsbedingungen (keine vollständige Wasserfüllung der Poren, kein vollständiges Austrocknen)

Hierbei gilt für die Carbonatisierungstiefe Folgendes:
- Im Freien unter höherer relativer Luftfeuchte bzw. unter Regeneinfluss verläuft die Carbonatisierung langsamer, da das durch den Niederschlag aufgenommene Wasser den CO2-Transport durch die Kapillarporen verhindert.
- Mit steigendem w/z-Wert (Wasser/Zement-Wert) erhöht sich der Kapillarporenanteil und damit die Gasdurchlässigkeit des Zementsteins.
- Bei der Hydratation von Portlandzement werden vor allem die Klinkerphasen C3S und C2S zu Calciumsilikathydraten hydratisiert unter der Bildung von Ca(OH)2. Je höher die Menge an Ca(OH)2 desto mehr CO2 wird gebunden, was die Carbonatisierungstiefe reduziert. Zudem nehmen die bei der Carbonatisierung neu gebildeten Phasen ein größeres Volumen ein, was die Porosität in der carbonatisierten Zone verringert und den Diffusionswiderstand erhöht.
- Tonerdezemente weisen im Vergleich zu Portlandzementen eine 2 bis 3-mal größere Carbonatisierungstiefe auf, da keine Ca(OH)2-Bildung während der Hydratation erfolgt.

Demnach nimmt die Carbonatisierungstiefe mit höherem Ca(OH)2-Gehalt, geringerem w/z-Wert und zunehmender Dichte des Zements ab.

Außerdem erfolgt ein weiteres Sinken des pH-Wertes durch:
- Erhöhte CO2-Konzentrationen in der Luft
- Vollständigen Verbrauch an Ca(OH)2 aus der Porenlösung
- Zusätzliches Ausfallen von Alkalien aus der Porenlösung durch z.B. Kieselsäure SiO2 · nH2O (SiO2ist nur sehr gering in Wasser löslich)

   2KOH + SiO2 + n H2O K2SiO3 · n H2O

Im Stand der Technik wird eine Vielzahl von Abhilfemaßnahmen zur Verhinderung der Carbonatisierung bzw. Minimierung der Carbonatisierungstiefe offenbart, wie bspw. die äußere Beschichtung der Zementmasse mit einer Schutzschicht, um das Eindringen von CO2 und Feuchtigkeit zu verhindern, und eine Wärmebehandlung zur Erzielung einer möglichst vollständigen Hydratation des Zements.

Außerdem wird die bevorzugte Verwendung von Portlandzementen mit hohem C3S- und C2S-Gehalt (z.B. CEM I) empfohlen, da diese - wie vorangehend beschrieben - einen langsameren Carbonatisierungsfortschritt als Zemente mit vermindertem Klinkeranteil, wie bspw. Tonerdezemente zeigen. Ferner nimmt die Carbonatisierungstiefe mit steigendem Alkaligehalt ab, d.h. der Carbonatisierungsfortschritt wird gehemmt. Der Grund ist die schnellere Anfangshydratation alkalireicher Zemente, was zu einem frühzeitig dichten Gefüge führt.

Aus der DE102013112267A1 ist ein Halbleitermodul mit einer einen Halbleiterbaustein bedeckenden Umhüllungsmasse aus verschiedenen Zementarten bekannt. Die Umhüllmasse weist hierbei einen feuchtebeständigen Überzug (Schutzmasse oder Lack) auf, welcher in einem separaten Fertigungsschritt nach dem Abbinden der Zementmasse aufgetragen wird, um ein Eindringen von Feuchtigkeit in den Zement zu verhindern. In der EP 0 084 951 A2 wird vorgeschlagen, eine Kohlstoff- und Feuchtigkeitssperre auf Zement aufzubringen, um die Carbonatisierung des Zements zu verringern, um die Alkalität im Zement weitestgehend beizubehalten und dadurch den Eisen oder Stahl im Zement zu schützen.

### Offenbarung der Erfindung

Gegenstand der vorliegenden Erfindung ist ein Verfahren zur Herstellung einer elektrischen Vorrichtung mit einem elektrischen oder elektronischen Bauteil, wobei das Bauteil von einer Zement aufweisenden Umhüllmasse zumindest teilweise umhüllt wird, mit folgenden Schritten:
- Aufbringen der Umhüllmasse auf das elektrische oder elektronische Bauteil; und
- Behandeln der Umhüllmasse derart, dass an einer Oberfläche der Umhüllmasse eine gezielte Carbonatisierung des Zements abläuft bzw. erfolgt,
wobei der Schritt des Behandelns der Umhüllmasse zur gezielten Carbonisierung des Zements an der Oberfläche folgende Schritte umfasst:
- erstes Wärmebehandeln der Umhüllmasse;
- Ausbilden eines Feuchtigkeitsfilms an der Oberfläche der Umhüllmasse; und
- zweites Wärmebehandeln der Umhüllmasse unter einer definierten Atmosphäre mit einem Kohlenstoffdioxid-Gehalt von größer 0,039 Vol.-% oder Kohlenstoffdioxid-Partialdruck von größer 0,039 kPa oder gleich 0,039 kPa bis kleiner 0,01 KPa aufweist.

Die elektrische Vorrichtung kann als Leistungselektronik-Modul ausgebildet sein.

Das elektrische oder elektronische Bauteil kann ausgewählt sein aus der Gruppe bestehend aus: Halbleiterbauelement, Sensorelement, Induktivität, Kapazität, Batteriezelle, Batteriemodul, Schaltung. Unter einem elektrischen oder elektronischen Bauteil kann im Rahmen der vorliegenden Erfindung jedoch jegliches aktive und passive Bauelement bzw. Hochleistungs-Bauelement verstanden werden. Die elektrische Vorrichtung kann hierbei zumindest ein weiteres Element aufweisen, welches ausgewählt aus der Gruppe bestehend aus: Elektrode, Bauteilkontaktierung, Trägersubstrat, Anbindungselement, insbesondere Bauteilanbindungselement und/oder Trägersubstratanbindungselement.

Unter einem Zement kann im Rahmen der vorliegenden Erfindung ein anorganisches, metallfreies, hydraulisches Bindemittel verstanden werden. Der Zement erhärtet hierbei hydraulisch, d.h. es findet eine chemische Reaktion mit Wasser statt unter Bildung stabiler, unlöslicher Verbindungen. Hierbei kann der Zement zu Beginn des Verfahrens bzw. vor der Hydratation als feingemahlenes Pulver ausgebildet sein, welches mit Wasser bzw. Zugabewasser unter der Bildung von Hydraten reagiert, erstarrt und erhärtet. Die Hydrate können dabei Nadeln und/oder Plättchen ausbilden, welche sich verzahnen und somit zu einer hohen Festigkeit des Zementes führen. Im Gegensatz dazu erhärtet ein Phosphatzement nicht hydraulisch. Es findet eine Säure-Basen-Reaktion unter Bildung eines Salzgels statt, welches später zu einer meist amorphen Masse erstarrt. Bei der Säure-Base-Reaktion werden H+ (Wasserstoff-Ionen) ausgetauscht.

Der Zement kann überwiegend aus Calciumaluminaten bestehen und während der Hydratation Calciumaluminathydrate ausbilden. Der Zement kann vor der Hydratation einen w/z-Wert (Wasser/Zement-Wert) von ca. 0,35 (bei Tonerdezement) bis ca. 0,4 (bei Portlandzement) aufweisen.

Unter einer Umhüllmasse kann im Rahmen der vorliegenden Erfindung jegliche Art von Verkapselung (Packaging) verstanden werden. Die Umhüllmasse weist Zement auf. Die Umhüllmasse basiert bevorzugt auf Zement. Die Umhüllmasse kann als Zementkomposit ausgebildet sein. D.h., mit anderen Worten, dass die Umhüllmasse eine Zementmatrix mit einem Füllstoff sowie den Zusatzstoff aufweisen kann. Die Umhüllmasse kann vor und/oder nach dem Schritt des Behandelns folgende Zusammensetzung aufweisen:
- Bindemittel Tonerdezement: größer oder gleich 8 bis kleiner oder gleich 47 Gew.-% (bspw. SECAR 71)
- Reaktionsmittel Wasser: größer oder gleich 10 bis kleiner oder gleich 28 Gew.-%
- Zusatzstoff: 3-20 Gew.-%
- Füllstoff: größer oder gleich 25 bis kleiner oder gleich 82 Gew.-%

Der Füllstoff kann ausgewählt sein aus der Gruppe bestehend aus:
- Al2O3: fein d50 ca. 1 µm bis grob d50 ca. 150-200 µm
- Alpha-Si3N4: fein ca. 1 µm bis grob ca. 100 µm
- Hex. BN: fein ca. 15 µm oder bis ca. 250 µm
- SiC: fein ca. 10-50 µm oder bis ca. 600 µm
- AIN: fein ca. 1 µm oder bis ca. 100 µm

Die Umhüllmasse kann im Schritt des Aufbringens angrenzend an das Bauteil und ggf. an ein weiteres Element angeordnet werden. Demnach kann die Umhüllmasse eine Kontaktfläche mit dem Bauteil und ggf. mit dem weiteren Element aufweisen.

Der Schritt des Behandelns kann eine Vielzahl von Teilschritten umfassen. Der Schritt des Behandelns kann einen Hydratationsschritt und/oder Abbindeschritt und/oder Trocknungsschritt und/oder Aushärtungsschritt umfassen.

Die Oberfläche der Umhüllmasse weist hierbei Kapillarwände bzw. Kapillarporen auf. Die Oberfläche der Umhüllmasse kann vorteilhafterweise eine gesamte Außenfläche der Umhüllmasse sein, welche Fluiden aus der der Vorrichtung umgebenden Atmosphäre aussetzbar ist, wobei bei der Behandlung der Umhüllmasse der Zement an der gesamten Oberfläche gezielt carbonatisiert. Bei der Oberfläche der Umhüllmasse handelt es sich demnach nicht um die Grenzfläche zwischen der Umhüllmasse und dem elektronischen Bauteil bzw. Bauelement.

Unter einer gezielten Carbonatisierung kann im Rahmen der vorliegenden Erfindung eine gezielt gesteuerte bzw. regulierte Carbonatisierung verstanden werden. Die gezielte Carbonatisierung erfolgt hierbei unter einer definierten Atmosphäre. Die gezielte Carbonatisierung ist hierbei gewünscht und bewusst herbeigeführt, wobei der Ablauf reguliert abläuft bzw. erfolgt. Hierbei wird die Oberfläche der Umhüllmasse derart behandelt, dass die gezielt carbonatisierte Oberfläche im Wesentlichen gleichmäßig reagiert. Demnach weist die gesamte gezielt carbonatisierte Oberfläche eine im Wesentlichen flächig homogene Carbonatisierungsverteilung auf. D.h., die gesamte Oberfläche ist in ihrer Längs- und Querrichtung gleichmäßig bzw. homogen carbonatisiert. Die Carbonatisierungsverteilung kann in Tiefenrichtung der Umhüllmasse jedoch auch variieren.

Entgegen der bisher bekannten Ansätze und Anstrengungen zur Verhinderung der Carbonatisierung bzw. Minimierung der Carbonatisierungstiefe im Zement bzw. Stahlbeton, um eine Korrosion des Eisens bzw. des Stahls aufgrund der pH-Absenkung zu unterbinden, wird nunmehr bei der vorliegenden Erfindung eine Carbonatisierung des Zements in der Umhüllmasse gezielt herbeigeführt und gefördert, wobei die unerwünschte pH-Absenkung hierbei bewusst in Kauf genommen wird. Demnach können durch das erfindungsgemäße Verfahren die Vorteile der Carbonatisierung ausgenutzt werden, so dass an der Oberfläche der Umhüllmasse, an der die gezielte Carbonatisierung erfolgt
- eine Zunahme der Dichte des Zementgefüges infolge der Volumenzunahme (V) durch das neu gebildete Calciumcarbonat

   Ca(OH)2→ CaCO3 V = +11%
- eine Erhöhung der Dichtigkeit gegenüber Wasser und Gasen durch Abnahme des Gesamtporenvolumens um 20 bis 28 % sowie
- eine Erhöhung der Zementfestigkeit um 20 bis 50 % in Abhängigkeit von der Zementart
erfolgen. Somit weist die mittels des Verfahrens hergestellte elektrische Vorrichtung eine Umhüllmasse mit einer an der Oberfläche bzw. am Randbereich erhöhten Dichtigkeit gegenüber Feuchtigkeit und Gasen, wie bspw. SO2-Gas aus Verbrennungsabgasen, das in Gegenwart von Feuchtigkeit in schweflige Säure und durch Oxidation in Schwefelsäure übergehen kann. Hierbei kommt es dann zu einem Säureangriff im Beton, was zur Herabsetzung des pH-Wertes und anschließender Korrosion führt

S + 02 → SO2

SO2 + ½ 02 + H2O → H2SO4

Zudem wird durch die erhöhte Dichtigkeit die Festigkeit erhöht. Um die Korrosionsgefahr der Metalle aufgrund des gesunkenen pH-Wertes in der Umhüllmasse zu unterbinden und damit die Funktionsfähigkeit der elektrischen Vorrichtung bzw. des Leistungselektronik-Moduls zu gewährleisten, müssen hierbei Metalle, welche eine Kontaktfläche zu der Umhüllmasse aufweisen, in Abhängigkeit von dem sich einstellenden pH-Bereich entsprechend ausgewählt werden bzw. in diesem pH-Bereich korrosionsbeständig sein.

Hierbei ist es insbesondere vorteilhaft, wenn der Schritt des ersten Wärmebehandelns vor einer vollständigen Hydratation des Zements der Umhüllmasse abgebrochen wird, so dass eine Carbonatisierung effizient ablaufen kann. Der Zement kann vor der Hydratation einen w/z-Wert (Wasser/Zement-Wert) von ca. 0,35 (bei Tonerdezement) bis ca. 0,4 (bei Portlandzement) aufweisen. Die erste Wärmebehandlung kann einen Temperschritt in einem Temperofen unter einer definierten Atmosphäre umfassen. Die erste Wärmebehandlung kann in einem Temperaturbereich von größer oder gleich 40°C bis kleiner oder gleich 300°C erfolgen. Die definierte Atmosphäre kann bspw. eine Luft mit einer erhöhten Luftfeuchtigkeit von bis zu 100% sein. Die definierte Atmosphäre kann auch Katalysator- oder Beschleuniger-Moleküle aufweisen. Des Weiteren ist es insbesondere vorteilhaft, wenn im Schritt des Ausbildens des Feuchtigkeitsfilms ein Abkühlen der Umhüllmasse, insbesondere auf annähernd Raumtemperatur (20°C), unter einer definierten Atmosphäre mit einer relativen Feuchtigkeit bzw. relative Luftfeuchtigkeit von größer oder gleich 60% bis kleiner oder gleich 80%, bevorzugt im Wesentlichen 65%, oder ein Aufbringen von Wasser auf die Oberfläche der Umhüllmasse umfasst. Die zweite Wärmebehandlung kann einen Temperschritt in einem Temperofen unter einer definierten Atmosphäre umfassen. Die zweite Wärmebehandlung kann in einem Temperaturbereich von größer oder gleich 95°C bis kleiner oder gleich 300°C erfolgen. Die definierte Atmosphäre kann eine relative Feuchtigkeit bzw. relative Luftfeuchtigkeit von größer oder gleich 60% bis kleiner oder gleich 80%, bevorzugt im Wesentlichen 65% aufweisen. Die definierte Atmosphäre kann auch Katalysator- oder Beschleuniger-Moleküle aufweisen. Durch diese Maßnahme kann auf einfache Art und Weise an einer Oberfläche der Umhüllmasse eine Carbonatisierung des Zements gezielt ausgelöst bzw. gezielt durchgeführt werden. Zum einen kann aufgrund der abgebrochenen, d.h. unvollständigen Hydratation des Zements in der ersten Wärmebehandlung und der anschließenden Abkühlung auf ca. Raumtemperatur bei einer definierten Feuchtigkeit bzw. Luftfeuchtigkeit ein Feuchtigkeitsfilm an der Oberfläche bzw. den Kapillarwänden der Oberfläche ausgebildet werden. Bei der anschließenden zweiten Wärmebehandlung unter einem definierten Kohlenstoffdioxid-Gehalt kommt es zu einer Carbonatisierung an der Oberfläche von außen nach innen, wobei gleichzeitig ein Teil des überschüssigen Wassers von bzw. aus dem Zement verdampft. Demnach verliert der Zement an der Oberfläche langsam überschüssiges Porenwasser ("trocknet aus") und das Zementgefüge wird dichter, so dass mittels diesem "Schutzbereich" ein weiteres Eindringen von Feuchtigkeit und Gasen verhindert wird. Gleichzeitig wird die restliche Porenlösung weniger alkalisch. Die maximale Carbonatisierungsgeschwindigkeit wird bei einer relativen Luftfeuchtigkeit von größer oder gleich 60% bis kleiner oder gleich 80% erreicht.

Es ist außerdem vorteilhaft, wenn die Zementmasse Tonerdezement aufweist, insbesondere aus Tonerdezement besteht. Tonerdezement (Kurzzeichen CAC) ist nach DIN EN 14647 europäisch geregelt. Tonerdezement besteht vorwiegend aus Monocalciumaluminat (CaO * Al2O3).

Der Tonerdezement kann bspw. folgende Zusammensetzung aufweisen:
- Al2O3: größer oder gleich 67,8 Gew.-%
- CaO: kleiner oder gleich 31,0 Gew.-%
- SiO2: kleiner oder gleich 0,8 Gew.-%
- Fe2O3: kleiner oder gleich 0,4 Gew.-%

Tonerdezemente weisen im Vergleich z.B. zu Portlandzementen eine 2 bis 3-mal größere Carbonatisierungstiefe auf, da keine Ca(OH)2-Bildung während der Hydratation erfolgt. Da die Carbonatisierung des Zements gewünscht und gezielt durchgeführt wird, kann durch die Verwendung von Tonerdezement die Carbonatisierung an der Oberfläche der Umhüllmasse schneller, einfacher und effektiver ablaufen bzw. durchgeführt werden.

Des Weiteren ist es vorteilhaft, wenn das Bauteil und/oder das weitere Element an einer Kontaktfläche mit der Umhüllmasse einen metallischen Bereich aufweist, wobei der metallische Bereich frei von Metallen ist, welche in Umgebungen bzw. Lösung mit einem pH-Wert von größer oder gleich 7 bis kleiner oder gleich 9 im Wesentlichen korrosionsunbeständig sind. D.h., mit anderen Worten, dass der metallische Bereich ausschließlich Metalle aufweist, in Umgebungen bzw. Lösungen mit einem pH-Wert von größer oder gleich 7 bis kleiner oder gleich 9 im Wesentlichen korrosionsbeständig sind bzw. dass der metallische Bereich ausschließlich Metalle aufweist, in pH-neutralen bis leicht alkalischen Umgebungen bzw. Lösungen im Wesentlichen korrosionsbeständig sind. Hierbei ist es vorteilhaft, wenn das Bauteil und/oder das weitere Element an der Kontaktfläche mit der Umhüllmasse einen metallischen Bereich aufweist, wobei der metallische Bereich ausschließlich Metalle aufweist, welche ausgewählt sind aus der Gruppe bestehend aus: Kupfer (Cu), Kupferlegierung, Kupfer-Zinn-Legierung (CuSn-Legierung) und/oder Kupfer-Nickel-Legierung (CuNi-Legierung). Hierbei ist es insbesondere vorteilhaft, wenn die Kontaktfläche die gesamte Kontaktfläche zwischen Bauteil und Umhüllmasse sowie weiteren Elementen und Umhüllmasse ist. D.h., mit anderen Worten, dass alle metallischen Bereiche, welche eine Kontaktfläche zu der Umhüllmasse aufweisen, frei von Metallen sind, welche in Umgebungen mit einem pH-Wert von größer oder gleich 7 bis kleiner oder gleich 9 im Wesentlichen korrosionsunbeständig sind, wie z.B. Metalle, welche ausgewählt sind aus der Gruppe bestehend aus: Kupfer, Kupferlegierung, Kupfer-Zinn-Legierung und/oder Kupfer-Nickel-Legierung. Unter einem metallischen Bereich ist hierbei ein Bereich gemeint, welcher zumindest ein Metall aufweist oder aus zumindest einem Metall besteht. Der metallische Bereich kann jedoch auch weitere Nichtmetalle aufweisen, welche nicht korrosionsgefährdet sind. Da durch die Carbonatisierung der pH-Wert auf neutrale bis leicht alkalische Werte absinkt, kann durch diese Maßnahme eine Korrosion aller gefährdeten Metalle in der Umhüllmasse verhindert werden, so dass die Funktionsfähigkeit der elektrischen Vorrichtung bzw. des Leistungselektronik-Moduls gewährleistet bleibt. Kupfer und Kupferlegierungen, bspw. Kupfer-ZinnLegierungen und/oder Kupfer-Nickel-Legierungen sind gute elektrische Leiter und weisen eine gute Korrosionsbeständigkeit in neutralen und alkalischen Umgebungen bzw. Lösungen.

### Zeichnungen

Die Erfindung wird nachstehend anhand der beigefügten Zeichnungen beispielhaft näher erläutert. Es zeigen:
- Fig. 1: eine schematische Darstellung einer elektrischen Vorrichtung gemäß einem Ausführungsbeispiel der vorliegenden Erfindung;
- Fig. 2a-c: eine schematische Darstellung einer Sequenz des Verfahrens zur Herstellung einer erfindungsgemäßen Vorrichtung; und
- Fig. 3: ein Ablaufdiagramm eines Verfahrens zur Herstellung einer erfindungsgemäßen Vorrichtung.

In der nachfolgenden Beschreibung bevorzugter Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung der Elemente verzichtet wird.

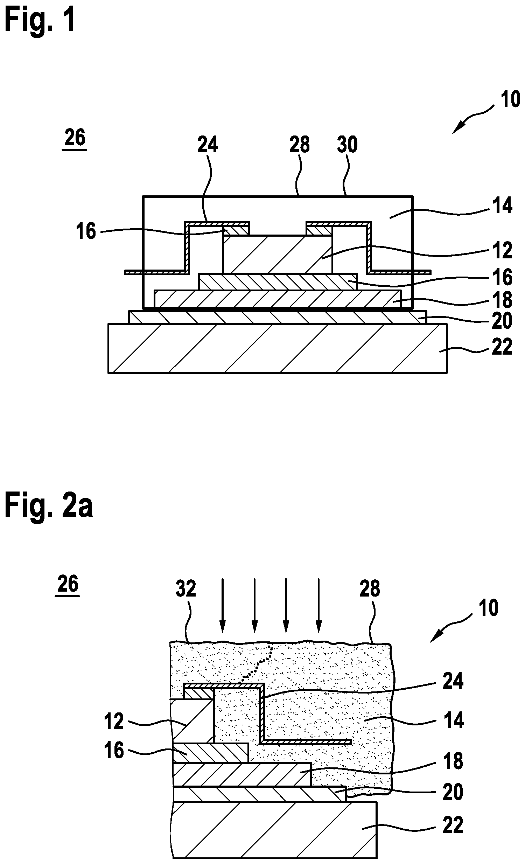

In Fig. 1 ist eine erfindungsgemäße elektrische Vorrichtung dargestellt, welche in ihrer Gesamtheit mit der Bezugsziffer 10 versehen ist.

Die elektrische Vorrichtung 10 weist ein elektrisches bzw. elektronisches Bauteil 12 und eine Umhüllmasse 14 auf.

Das elektrische bzw. elektronische Bauteil 12 ist als Halbleiterbauelement 12 ausgebildet. Das elektronische Bauteil 12 ist mittels eines Bauteilanbindungselements 16, welches als Kontaktschicht 16 bzw. Lotschicht 16 ausgebildet ist, an einem Trägersubstrat 18 angeordnet bzw. mit diesem elektrisch und mechanisch verbunden. Das Trägersubstrat 18 ist als eine Platte ausgebildet, in der Leiterbahnen bzw. elektrische Kontakte zum Kontaktieren des elektrischen Bauteils 12 integriert sind. Die Leiterbahnen sind auf einer Oberfläche des Trägersubstrats 18 angeordnet.

Das Trägersubstrat 18 ist wiederum mittels eines Substratanbindungselements 20, welches als thermischer Leitkleber 20 ausgebildet ist, an einem Kühlkörper 22 (Wärmesenke) angeordnet bzw. mit diesem elektrisch und mechanisch verbunden.

Um eine elektrische Kontaktierung des elektronischen Bauteils 12 von außen, d.h. von außerhalb der Umhüllmasse 14, zu ermöglichen, sind ferner Bauteilkontaktierungen 24 vorgesehen. Die Bauteilkontaktierungen 24 sind mittels Bauteilanbindungselementen 16, welche als Kontaktschichten 16 bzw. Lotschichten 16 ausgebildet sind, mit dem elektronischen Bauteil 12 elektrisch und mechanisch verbunden und erstrecken sich von dem Inneren der Umhüllmasse 14 bis in eine Atmosphäre 26 bzw. Umgebung 26 außerhalb der Umhüllmasse 14.

Die Umhüllmasse 14 weist Zement auf bzw. basiert auf Zement. Die Umhüllmasse 14 ist an bzw. auf dem Trägersubstrat 18 angeordnet. Die Umhüllmasse 14 umhüllt hierbei das elektronische Bauteil 12 an den freien Flächen, welche nicht zur Kontaktierung dienen. Demnach ist das elektronische Bauteil 12 vollständig durch das Trägersubstrat 18 und die Umhüllmasse 14 umhüllt. Die Umhüllmasse 14 weist jeweils eine Kontaktfläche bzw. Kontaktflächen zu dem elektronischen Bauteil 12, den Kontaktschichten 16, dem Trägersubstrat 18, dem Leitkleber 20 und den Bauteilkontaktierungen 24 auf.

Die Umhüllmasse 14 weist ferner eine Oberfläche 28 auf. Die Oberfläche 28 ist hierbei eine gesamte Außenfläche 28 der Umhüllmasse 14, welche Fluiden aus der der Vorrichtung 10 umgebenden Atmosphäre 26 aussetzbar ist. D.h., mit anderen Worten, dass die Außenfläche 28 die Kontaktfläche der Umhüllmasse 14 mit der Atmosphäre 26 bzw. der Umgebung 26 ist.

Erfindungsgemäß weist die Oberfläche 28 der Umhüllmasse 14 carbonatisierten Zement 30 auf. Bevorzugt weist die gesamte Außenfläche 28 der Umhüllmasse 14 carbonatisierten Zement 30 auf. Wie anhand der Fig. 2a-c nachfolgend näher erläutert wird, wurde dies über eine Behandlung mit einer gezielten Carbonatisierung des Zements 30 an der Oberfläche der Umhüllmasse 14 erreicht. Hierbei weist die gesamte gezielt carbonatisierte Oberfläche 28 bzw. Außenfläche 28 eine im Wesentlichen flächig homogene Carbonatisierungsverteilung des carbonatisierten Zements 30 auf. Demnach ist die gesamte Oberfläche 28 bzw. der Zement 30 in ihrer Längs- und Querrichtung gleichmäßig bzw. homogen carbonatisiert. Der carbonatisierte Zement 30 führt dazu, dass die Oberfläche 28 der Umhüllmasse 14 eine höhere Festigkeit aufweist und dichter ist, wodurch das Eindringen von CO2 und 02 sowie von Feuchtigkeit aus der Umgebung 26 in die Umhüllmasse 14 verhindert wird.

Durch die Carbonatisierung sinkt jedoch die Alkalität des Zements auf einen pH-Bereich von im Wesentlichen größer oder gleich 7 bis kleiner oder gleich 9. Da das elektronische Bauteil 12, die Kontaktschichten 16, das Trägersubstrat 18, der Leitkleber 20 und die Bauteilkontaktierungen 24 jeweils an der Kontaktfläche bzw. den Kontaktflächen mit der Umhüllmasse 14 einen metallischen Bereich aufweisen, wird hierbei bei der Auswahl der Metalle der gesunkene pH-Wert berücksichtigt. Um nun eine Korrosion der Metalle in diesen metallischen Bereichen aufgrund der gesunkenen Alkalität des Zements zu vermeiden, sind die metallischen Bereich frei von Metallen, welche in Umgebungen bzw. Lösungen mit einem pH-Wert von größer oder gleich 7 bis kleiner oder gleich 9 im Wesentlichen korrosionsunbeständig sind. Demnach weisen die metallischen Bereiche an den Kontaktflächen mit der Umhüllmasse 14 ausschließlich Metalle auf, welche in Umgebungen bzw. Lösungen mit einem pH-Wert von größer oder gleich 7 bis kleiner oder gleich 9, d.h. in pH-neutralen bis leicht alkalischen Umgebungen im Wesentlichen korrosionsbeständig sind. Hierdurch kann die Funktionsfähigkeit der elektrischen Vorrichtung bzw. des Leistungselektronik-Moduls trotz gesunkenem pH-Wert gewährleistet werden.

Das elektronische Bauelement 12 kann bspw. in den metallischen Bereichen an der Kontaktfläche mit der Umhüllmasse 14 ausschließlich Cu aufweisen. Die Kontaktschicht 16 kann bspw. in den metallischen Bereichen an der Kontaktfläche mit der Umhüllmasse 14 ausschließlich SnAgCu (Weichlot) und/oder Cu (Diffusionslot) aufweisen. Das Trägersubstrat 18 kann bspw. in den metallischen Bereichen an der Kontaktfläche mit der Umhüllmasse 14 (Leiterbahnen usw.) ausschließlich Cu aufweisen. Der Leitkleber 20 kann bspw. in den metallischen Bereichen an der Kontaktfläche mit der Umhüllmasse 14 ausschließlich SnAgCu (Weichlot) und/oder Cu (Diffusionslot) aufweisen. Die Bauteilkontaktierungen 24 können bspw. in den metallischen Bereichen an der Kontaktfläche mit der Umhüllmasse 14 ausschließlich Cu aufweisen.

In Fig. 2a-c ist sequenzartig der Ablauf der Behandlung bzw. Carbonatisierung der Oberfläche 28 der Umhüllmasse 14 dargestellt.

Fig. 2a zeigt, wie nach einer ersten Wärmebehandlung der Umhüllmasse 14 bei nicht vollständig hydratisiertem Zement in der Umhüllmasse 14 ein Feuchtigkeitsfilm 32 auf der Oberfläche 28 der Umhüllmasse 14 ausgebildet wird. Hierbei erfolgt eine Abkühlung der Atmosphäre 26 bzw. Oberfläche 28 auf annähernd Raumtemperatur unter einer relativen Luftfeuchtigkeit der Atmosphäre 26 von ca. 65%, wodurch sich der Feuchtigkeitsfilm 32 an den Kapillarwänden der Oberfläche 28 ausbildet.

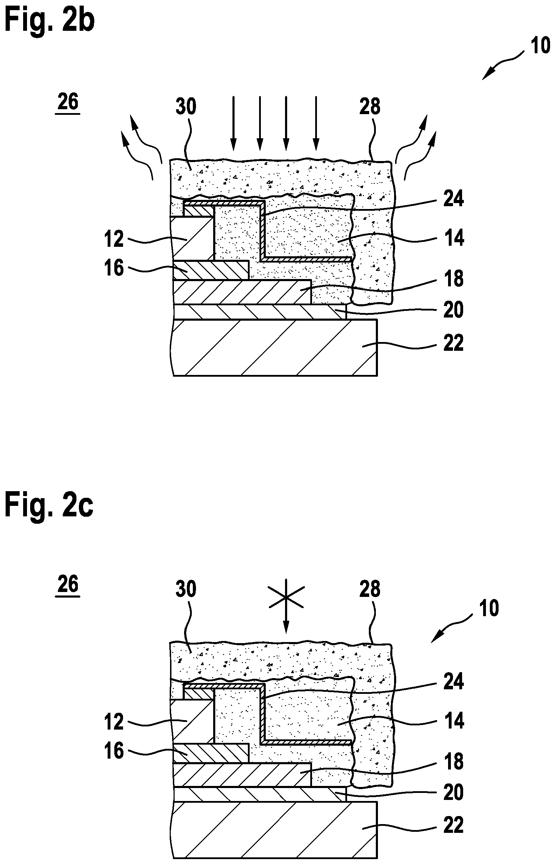

Fig. 2b zeigt, wie bei einer zweiten Wärmebehandlung der Umhüllmasse 14 unter einer definierten Atmosphäre mit einem Kohlenstoffdioxid-Gehalt von größer 0,039 Vol.-% oder Kohlenstoffdioxid-Partialdruck von größer 0,039 kPa oder gleich 0,039 kPa bis kleiner 0,01 KPa an der Oberfläche 28 der Umhüllmasse 14 eine gezielte Carbonatisierung des Zements 30 erfolgt. Hierbei wird die Oberfläche 28 auf über 100°C erwärmt und gleichzeitige der CO2-Druck in der Atmosphäre 26 leicht auf größer 0,039 kPa erhöht, so dass eine gezielte Carbonatisierung des Zements 30 von außen nach innen erfolgt und gleichzeitig ein Teil des überschüssigen Wassers aus der Umhüllmasse 14 verdampft.

In Fig. 2c ist schließlich die elektrische Vorrichtung 10 nach der gezielten Carbonatisierung des Zements 30 bzw. mit carbonatisiertem Zement 30 dargestellt. Hierbei hat sich durch die gezielte Carbonatisierung das Gefüge des Zements 30 an der Oberfläche 28 verdichtet (CaCO3-Bildung) und der pH-Wert ist auf neutrale bis leicht alkalische Werte gesunken. Somit weist die mittels des Verfahrens hergestellte elektrische Vorrichtung 10 eine Umhüllmasse 14 mit einer an der Oberfläche 28 bzw. am Randbereich erhöhten Dichtigkeit gegenüber Feuchtigkeit und Gasen, wie bspw. Kohlenstoffdioxid und Sauerstoff, sowie erhöhten Festigkeit auf. Da die metallischen Bereiche, welche in Kontakt mit der nunmehr leicht alkalischen Umhüllmasse 14 stehen, ausschließlich in dem entsprechenden pH-Bereich korrosionsbeständige Metalle aufweisen, besteht hierbei auch keine Korrosionsgefahr.

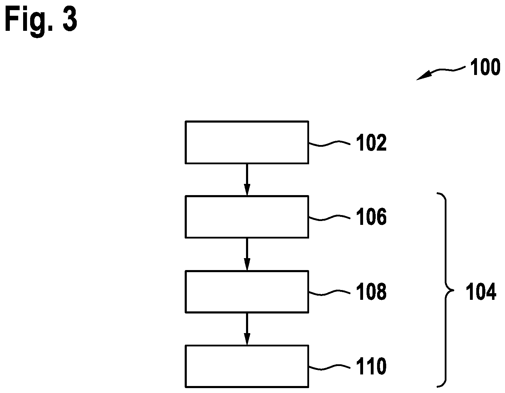

Fig. 3 zeigt ein Ablaufdiagramm eines Verfahrens 100 zur Herstellung einer erfindungsgemäßen elektrischen Vorrichtung 10.

Das Verfahren 100 umfasst einen Schritt 102 des Aufbringens der Umhüllmasse 14 auf das elektrische oder elektronische Bauteil 12. Ferner umfasst das Verfahren 100 einen Schritt 104 des Behandelns der Umhüllmasse 14 derart, dass an einer Oberfläche 28 der Umhüllmasse 14 eine gezielte Carbonatisierung des Zements erfolgt. Hierbei weist der Schritt 104 des Behandelns der Umhüllmasse 14 zur gezielten Carbonatisierung des Zements an der Oberfläche 28 einen Schritt 106 des ersten Wärmebehandelns der Umhüllmasse 14. Der Schritt 104 umfasst ferner einen Schritt 108 des Ausbildens eines Feuchtigkeitsfilms 32 an der Oberfläche 28 der Umhüllmasse 14. Schließlich umfasst der Schritt 104 einen Schritt 110 des zweiten Wärmebehandelns der Umhüllmasse 14 unter einer definierten Atmosphäre mit einem Kohlenstoffdioxid-Gehalt von größer 0,039 Vol.-% oder Kohlenstoffdioxid-Partialdruck von größer 0,039 kPa oder gleich 0,039 kPa bis kleiner 0,01 KPa.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Verfahren (100) zur Herstellung einer elektrischen Vorrichtung (10) mit einem elektrischen oder elektronischen Bauteil (12), wobei das Bauteil (12) von einer Zement aufweisenden Umhüllmasse (14) zumindest teilweise umhüllt wird, mit folgenden Schritten:
- Aufbringen (102) der Umhüllmasse (14) auf das elektrische oder elektronische Bauteil (12); und
- Behandeln (104) der Umhüllmasse (14) derart, dass an einer Oberfläche (28) der Umhüllmasse (14) eine gezielte Carbonatisierung des Zements erfolgt.
**dadurch gekennzeichnet, dass** der Schritt des Behandelns der Umhüllmasse (14) zur gezielten Carbonatisierung des Zements an der Oberfläche (28) folgende Schritte umfasst:
- erstes Wärmebehandeln (106) der Umhüllmasse (14);
- Ausbilden (108) eines Feuchtigkeitsfilms (32) an der Oberfläche (28) der Umhüllmasse (14); und
- zweites Wärmebehandeln (110) der Umhüllmasse (14) unter einer definierten Atmosphäre mit einem Kohlenstoffdioxid-Gehalt von größer oder gleich 0,039 Vol.-% oder Kohlenstoffdioxid-Partialdruck von größer 0,039 kPa oder gleich 0,039 kPa bis kleiner 0,01 KPa aufweist.

2. Verfahren (100) nach Anspruch 1, **dadurch gekennzeichnet, dass** der Schritt des erstes Wärmebehandelns (106) vor einer vollständigen Hydratation des Zements der Umhüllmasse (14) abgebrochen wird.

3. Verfahren (100) nach Anspruch 1 oder 2, **dadurch gekennzeichnet, dass** im Schritt des Ausbildens (108) des Feuchtigkeitsfilms (32) ein Abkühlen der Umhüllmasse (14), insbesondere auf annähernd Raumtemperatur, unter einer definierten Atmosphäre mit einer relativen Feuchtigkeit von größer oder gleich 60% bis kleiner oder gleich 80%, bevorzugt im Wesentlichen 65%, oder ein Aufbringen von Wasser auf die Oberfläche (28) der Umhüllmasse (14) umfasst.

4. Verfahren (100) nach einem der Ansprüche 1 bis 3, **dadurch gekennzeichnet, dass** im Schritt des zweiten Wärmebehandelns (110) die Umhüllmasse (14) auf größer oder gleich 100°C erwärmt wird.

5. Verfahren (100) nach einem der vorhergehenden Ansprüche, **dadurch gekennzeichnet, dass** die Oberfläche (28) der Umhüllmasse (14) eine gesamte Außenfläche (28) der Umhüllmasse (14) ist, welche Fluiden aus der der Vorrichtung (10) umgebenden Atmosphäre (26) aussetzbar ist, wobei bei der Behandlung (104) der Umhüllmasse (14) der Zement an der gesamten Oberfläche (28) gezielt carbonatisiert.

6. Verfahren (100) nach einem der vorhergehenden Ansprüche, **dadurch gekennzeichnet, dass** der Zement Tonerdezement ist.

7. Verfahren (100) nach einem der vorhergehenden Ansprüche, **dadurch gekennzeichnet, dass** das elektrische oder elektronische Bauteil (12) ausgewählt ist aus der Gruppe bestehend aus: Halbleiterbauelement (12), Sensorelement, Induktivität, Kapazität, Batteriezelle, Batteriemodul, Schaltung.

8. Verfahren (100) nach einem der vorhergehenden Ansprüche, **dadurch gekennzeichnet, dass** die Vorrichtung (10) zumindest ein weiteres Element (16, 18, 20, 24) aufweist, welches ausgewählt aus der Gruppe bestehend aus:
Elektrode, Bauteilkontaktierung (24), Trägersubstrat (18), Anbindungselement (16, 20), insbesondere Bauteilanbindungselement (16) und/oder Trägersubstratanbindungselement (20).

9. Verfahren (100) nach einem der vorhergehenden Ansprüche, **dadurch gekennzeichnet, dass** das Bauteil (12) und/oder das weitere Element (16, 18, 20, 24) an einer Kontaktfläche mit der Umhüllmasse (14) einen metallischen Bereich aufweist, wobei der metallische Bereich frei von Metallen ist, welche in Umgebungen mit einem pH-Wert von größer oder gleich 7 bis kleiner oder gleich 9 im Wesentlichen korrosionsunbeständig sind.

10. Verfahren (100) nach einem der vorhergehenden Ansprüche, **dadurch gekennzeichnet, dass** das Bauteil (12) und/oder das weitere Element (16, 18, 20, 24) an einer Kontaktfläche mit der Umhüllmasse (14) einen metallischen Bereich aufweist, wobei der metallische Bereich ausschließlich Metalle aufweist, welche ausgewählt sind aus der Gruppe bestehend aus: Kupfer, Kupferlegierung, Kupfer-Zinn-Legierung und/oder Kupfer-Nickel-Legierung.

11. Verfahren (100) nach Anspruch 9 oder 10, **dadurch gekennzeichnet, dass** die Kontaktfläche die gesamte Kontaktfläche zwischen Bauteil (12) und Umhüllmasse (14) sowie weiteren Elementen (16, 18, 20, 24) und Umhüllmasse (14) ist.

12. Elektrische Vorrichtung (10) mit einem elektrischen oder elektronischen Bauteil (12) und ggf. einem weiteren Element (16, 18, 20, 24), hergestellt nach einem der Ansprüche 1 bis 11.

## Claims

1. Method (100) for producing an electrical device (10) having an electrical or electronic component (12), the component (12) being at least partly enveloped by an envelope material (14) comprising cement, with steps as follows:
- applying (102) the envelope material (14) to the electrical or electronic component (12); and
- treating (104) the envelope material (14) in such a way that the cement is specifically carbonated at a surface (28) of the envelope material (14),
**characterized in that** the step of treating the envelope material (14) for the specific carbonation of the cement at the surface (28) comprises steps as follows:
- first heat-treating (106) of the envelope material (14) ;
- formation (108) of a moisture film (32) at the surface (28) of the envelope material (14); and
- second heat-treating (110) of the envelope material (14) under a defined atmosphere having a carbon dioxide content of greater than or equal to 0.039 vol% or carbon dioxide partial pressure of greater than 0.039 kPa or equal to 0.039 kPa to less than 0.01 KPa.

2. Method (100) according to Claim 1, **characterized in that** the step of first heat-treating (106) is discontinued before complete hydration of the cement in the envelope material (14).

3. Method (100) according to Claim 1 or 2, **characterized in that** the step of formation (108) of the moisture film (32) comprises a cooling of the envelope material (14), in particular to approximately room temperature, under a defined atmosphere having a relative humidity of greater than or equal to 60% to less than or equal to 80%, preferably substantially 65%, or an application of water to the surface (28) of the envelope material (14) .

4. Method (100) according to any of Claims 1 to 3, **characterized in that** in the step of the second heat-treating (110) the envelope material (14) is heated to greater than or equal to 100°C.

5. Method (100) according to any of the preceding claims, **characterized in that** the surface (28) of the envelope material (14) is an entire outer face (28) of the envelope material (14) which can be exposed to fluids from the atmosphere (26) surrounding the device (10), with specific carbonation of the cement at the entire surface (28) during the treatment (104) of the envelope material (14) .

6. Method (100) according to any of the preceding claims, **characterized in that** the cement is calcium aluminate cement.

7. Method (100) according to any of the preceding claims, **characterized in that** the electrical or electronic component (12) is selected from the group consisting of: semiconductor component (12), sensor element, inductance, capacitance, battery cell, battery module, circuit.

8. Method (100) according to any of the preceding claims, **characterized in that** the device (10) comprises at least one further element (16, 18, 20, 24) which is selected from the group consisting of: electrode, component contact (24), carrier substrate (18), attachment element (16, 20), especially component attachment element (16) and/or carrier substrate attachment element (20).

9. Method (100) according to any of the preceding claims, **characterized in that** the component (12) and/or the further element (16, 18, 20, 24) has a metallic region at a contact face with the envelope material (14), the metallic region being free of metals which are substantially unresistant to corrosion in environments with a pH of greater than or equal to 7 or less than or equal to 9.

10. Method (100) according to any of the preceding claims, **characterized in that** the component (12) and/or the further element (16, 18, 20, 24) has a metallic region at a contact face with the envelope material (14), the metallic region containing exclusively metals selected from the group consisting of: copper, copper alloy, copper-tin alloy and/or copper-nickel alloy.

11. Method (100) according to Claim 9 or 10, **characterized in that** the contact face is the entire contact face between component (12) and envelope material (14) and also further elements (16, 18, 20, 24) and envelope material (14).

12. Electrical device (10) having an electrical or electronic component (12) and optionally a further element (16, 18, 20, 24), produced according to any of Claims 1 to 11.

## Revendications

1. Procédé (100) de réalisation d'un dispositif électrique (10) comprenant un composant électrique ou électronique (12), le composant (12) étant au moins partiellement enrobé par un composé d'enrobage (14) contenant du ciment, le procédé comprenant les étapes suivantes :
- appliquer (102) le composé d'enrobage (14) sur le composant électrique ou électronique (12) ; et
- traiter (104) le composé d'enrobage (14) de manière à effectuer une carbonatation ciblée du ciment sur une surface (28) du composé d'enrobage (14),
**caractérisé en ce que**, pour effectuer la carbonatation ciblée du ciment sur la surface (28), l'étape de traitement du composé d'enrobage (14) comprend les étapes suivantes :
- soumettre le composé d'enrobage (14) à un premier traitement thermique (106) ;
- former (108) un film d'humidité (32) sur la surface (28) du composé d'enrobage (14) ; et
- soumettre le composé d'enrobage (14) à un deuxième traitement thermique (110) sous une atmosphère définie ayant une teneur en dioxyde de carbone supérieure ou égale à 0,039 % en volume ou une pression partielle de dioxyde de carbone supérieure à 0,039 kPa ou allant de 0,039 kPa à moins de 0,01 kPa.

2. Procédé (100) selon la revendication 1, **caractérisé en ce que** l'étape du premier traitement thermique (106) est interrompue avant une hydratation complète du ciment du composé d'enrobage (14).

3. Procédé (100) selon la revendication 1 ou 2, **caractérisé en ce que** l'étape de formation (108) du film d'humidité (32) comprend un refroidissement du composé d'enrobage (14), notamment jusqu'à la température ambiante environ, sous une atmosphère définie dont l'humidité relative est supérieure ou égale à 60 % et inférieure ou égale à 80 %, de préférence sensiblement égale à 65 %, ou une application d'eau sur la surface (28) du composé d'enrobage (14).

4. Procédé (100) selon l'une des revendications 1 à 3, **caractérisé en ce que**, à l'étape du deuxième traitement thermique (110), le composé d'enrobage (14) est chauffé à une température supérieure ou égale à 100 °C.

5. Procédé (100) selon l'une des revendications précédentes, **caractérisé en ce que** la surface (28) du composé d'enrobage (14) est une surface extérieure totale (28) du composé d'enrobage (14) qui peut être soumise à des fluides qui proviennent de l'atmosphère (26) entourant le dispositif (10), le ciment étant carbonaté de manière ciblée sur toute la surface (28) lors du traitement (104) du composé d'enrobage (14).

6. Procédé (100) selon l'une des revendications précédentes, **caractérisé en ce que** le ciment est du ciment alumineux.

7. Procédé (100) selon l'une des revendications précédentes, **caractérisé en ce que** le composant électrique ou électronique (12) est choisi dans le groupe comprenant : un composant à semi-conducteur (12), un élément capteur, une inductance, une capacité, une cellule de batterie, un module de batterie, un circuit.

8. Procédé (100) selon l'une des revendications précédentes, **caractérisé en ce que** le dispositif (10) comporte au moins un autre élément (16, 18, 20, 24) qui est choisi dans le groupe comprenant : une électrode, un contact de composant (24), un substrat porteur (18), un élément de connexion (16, 20), notamment un élément de connexion de composant (16) et/ou un élément de connexion de substrat porteur (20).

9. Procédé (100) selon l'une des revendications précédentes, **caractérisé en ce que** le composant (12) et/ou l'autre élément (16, 18, 20, 24) comporte une zone métallique sur une surface de contact avec le composé d'enrobage (14), la zone métallique étant exempte de métaux qui sont sensiblement non corrosifs dans des environnements dont le pH est supérieur ou égal à 7 et inférieur ou égal à 9.

10. Procédé (100) selon l'une des revendications précédentes, **caractérisé en ce que** le composant (12) et/ou l'autre élément (16, 18, 20, 24) comporte une zone métallique sur une surface de contact avec le composé d'enrobage (14),
la zone métallique comportant exclusivement des métaux qui sont choisis dans le groupe comprenant : le cuivre, un alliage de cuivre, un alliage cuivre-étain et/ou un alliage cuivre-nickel.

11. Procédé (100) selon la revendication 9 ou 10, **caractérisé en ce que** la surface de contact est la surface de contact totale entre le composant (12) et le composé d'enrobage (14) ainsi que d'autres éléments (16, 18, 20, 24) et le composé d'enrobage (14).

12. Dispositif électrique (10) comprenant un composant électrique ou électronique (12) et éventuellement un autre élément (16, 18, 20, 24) réalisé selon l'une des revendications 1 à 11.
